# EUROPEAN PATENT APPLICATION

(11) **EP 3 758 077 A1**
(43) Date of publication of application: **30.12.2020**
(21) Application number: 19757057.5
(22) Date of filing: 25.02.2019
(51) Int. Cl.: H01L 33/50, F21V 19/00, F21Y 115/10

(54) **LIGHT EMITTING DEVICE AND LIGHTING DEVICE**

(30) Priority: 23.02.2018 JP 2018031169
(71) Applicant: Kyocera Corporation, Fushimi-ku, Kyoto-shi, Kyoto 612-8501 (JP)
(72) Inventor: KATOU, Hidetaka, Kyoto-shi, Kyoto 612-8501 (JP); KUSANO, Tamio, Kyoto-shi, Kyoto 612-8501 (JP)
(74) Representative: Viering, Jentschura & Partner mbB Patent- und Rechtsanwälte
(86) International application number: PCT/JP2019/007008
(87) International publication number: WO 2019/163983

(57) **Abstract**

A light-emitting device or an apparatus includes a light emitter including a light-emitting portion that emits first emission light having a first peak wavelength in a range of 360 to 430 nm, and a coating located over the light-emitting portion of the light emitter and containing a phosphor to emit, when excited by the first emission light, second emission light having a second peak wavelength in a range of 480 to 520 nm. The light-emitting device emits external emission light having a light intensity that decreases continuously from the second peak wavelength to a wavelength of 750 nm and from the first peak wavelength to a wavelength in a region of 360 nm or less, and having a peak region including the first peak wavelength and the second peak wavelength.

## Description

### FIELD

The present invention relates to a light-emitting device including a light emitter and phosphors, and to an illumination apparatus.

### BACKGROUND

Recent light-emitting devices may include semiconductor light emitters such as light-emitting diodes (LEDs) (hereafter, simply light emitters) as light sources, and recent illumination apparatuses may include such light-emitting devices mounted on substrates. These light-emitting devices or illumination apparatuses may be used in various manufacturing processes as an alternative to natural light, such as sunlight. With such light-emitting devices or illumination apparatuses, various operations can be carried out in situations without sunlight, such as indoors or at nighttime.

Such light-emitting devices or illumination apparatuses may be used as light sources with appropriate color tones for viewing plants or animals. In recent examples, such light-emitting devices may be used for illuminating living things (aquatic life) living in water such as in the sea to be viewed indoors. A known example of a light-emitting device (lamp) for underwater illumination is a light trap described in Japanese Unexamined Patent Application Publication No. 2001-269104.

However, reproducing the colors of aquatic life living at different depths of water appears difficult with the light-emitting device according to the known technique for illuminating the aquatic life for viewing or raising. More specifically, creating lighting environments similar to real lighting environments with natural light is difficult for aquatic life living at relatively deep water such as those living at depths of about 50 to 100 m.

### BRIEF SUMMARY

A light-emitting device according to one aspect of the present invention includes a light-emitter including a light-emitting portion that emits first emission light having a first peak wavelength in a range of 360 to 430 nm, and a coating located over the light-emitting portion of the light emitter and containing a phosphor to emit, when excited by the first emission light, second emission light having a second peak wavelength in a range of 480 to 520 nm. The light-emitting device emits external emission light having a light intensity that decreases continuously from the second peak wavelength to a wavelength of 750 nm and from the first peak wavelength to a wavelength in a region of 360 nm or less, and having a peak region including the first peak wavelength and the second peak wavelength.

An illumination apparatus according to another aspect of the present invention includes the light-emitting device with the above structure and a mounting board on which the light-emitting device is mounted.

### BRIEF DESCRIPTION OF DRAWINGS

Fig. 1 is a perspective view of a light-emitting device according to an embodiment of the present invention.
Fig. 2 is a cross-sectional view of the light-emitting device taken along a plane indicated by an imaginary line shown in Fig. 1.
Fig. 3 is an enlarged cross-sectional view of a part of the light-emitting device shown in Fig. 2.
Fig. 4 is a graph showing the spectrum of external emission light from the light-emitting device according to the embodiment of the present invention.
Fig. 5 is a graph showing a solar spectrum at a water depth of 50 m in addition to the graph in Fig. 4.
Fig. 6 is a graph showing the spectrum of external emission light from the light-emitting device according to another embodiment of the present invention.
Fig. 7 is a perspective view of an illumination apparatus according to the embodiment of the present invention.

### DETAILED DESCRIPTION

A light-emitting device and an illumination apparatus according to one or more embodiments of the present invention will now be described with reference to the accompanying drawings. The terms upper and lower herein are for descriptive purposes and do not intend to limit the directions in actual use of the light-emitting device and the illumination apparatus. The terms being suitable for raising or other similar terms herein refer to lighting environments for aquatic life to raise being reproduceable to be similar to real lighting environments for the aquatic life in water such as in the sea. The terms also mean that the aquatic life can grow and breed and be viewed appropriately in such lighting environments reproduced precisely. The colors are herein reproduced within, for example, the visible light region for visual observation. The terms in water and in the sea are herein interchangeable.

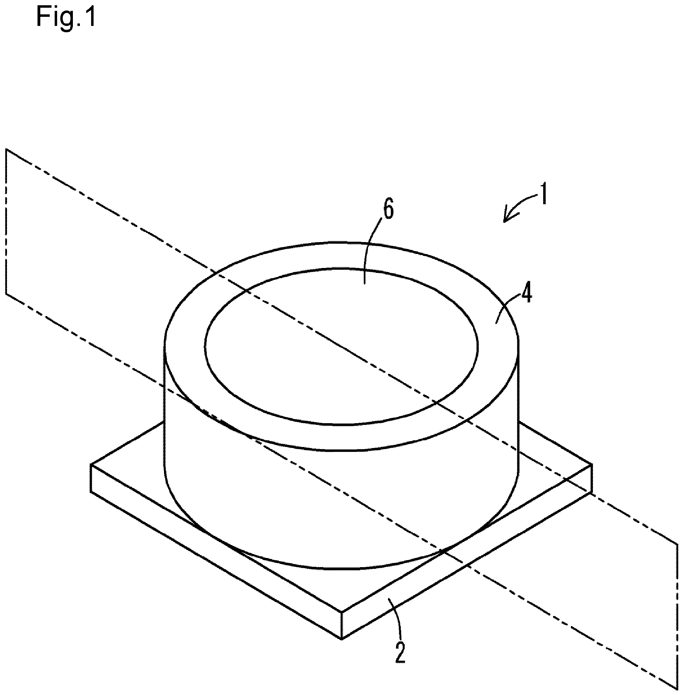

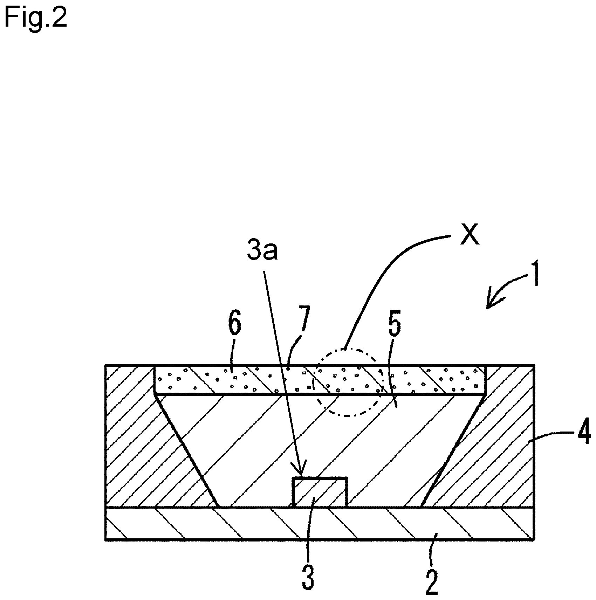

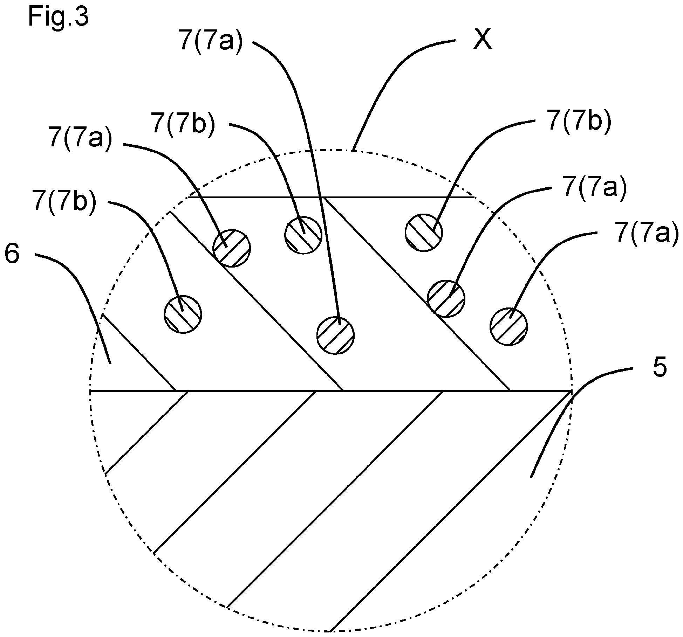

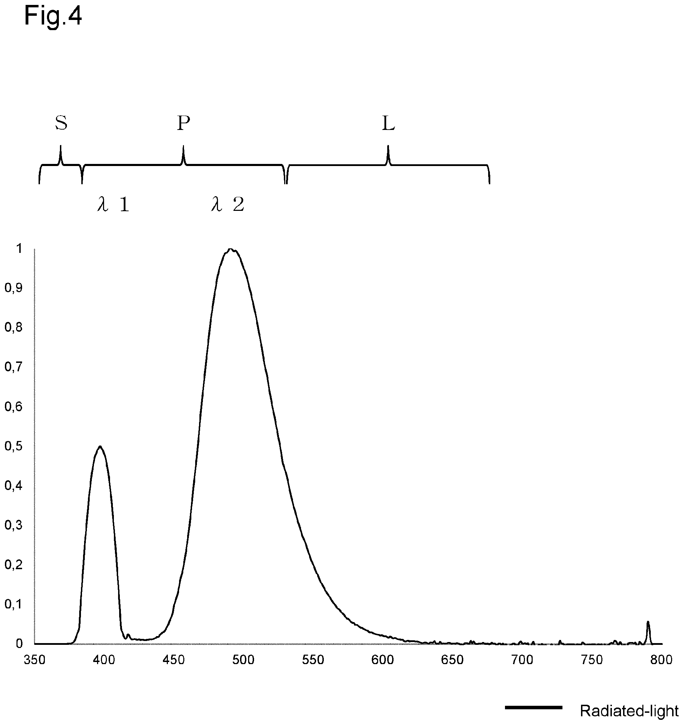

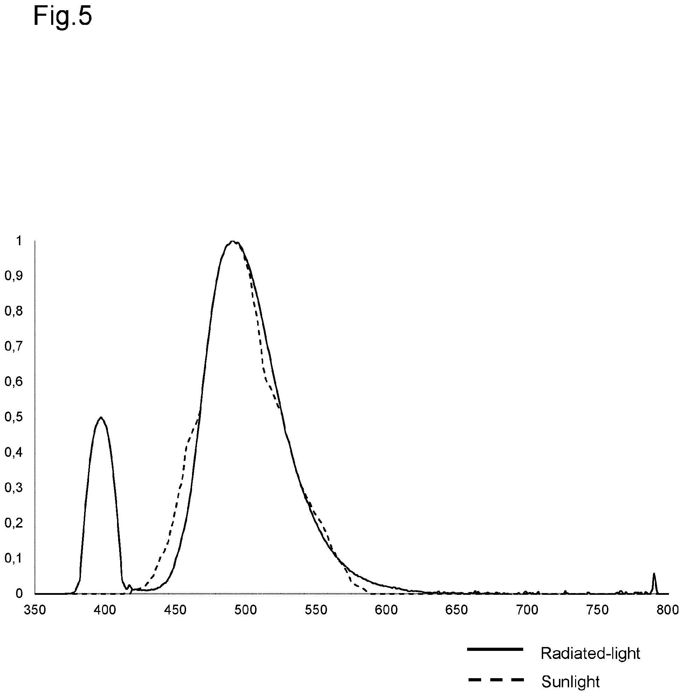

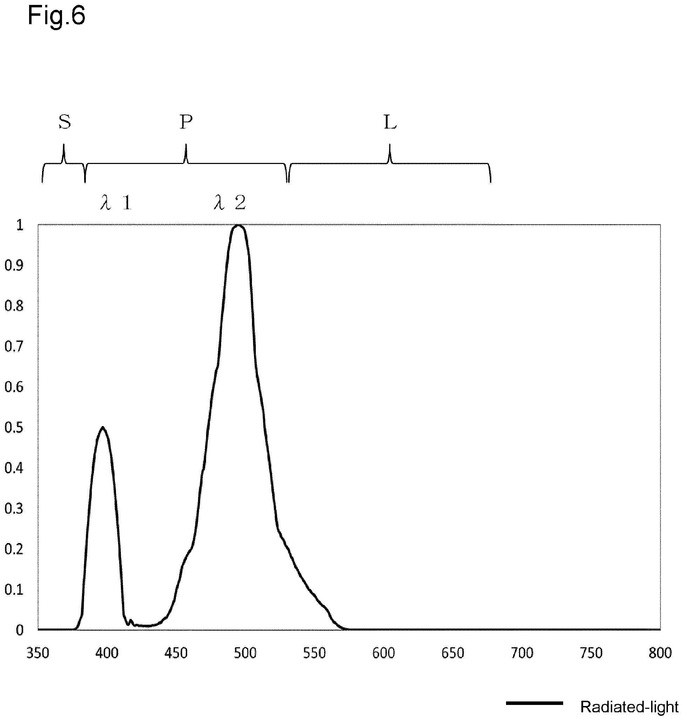

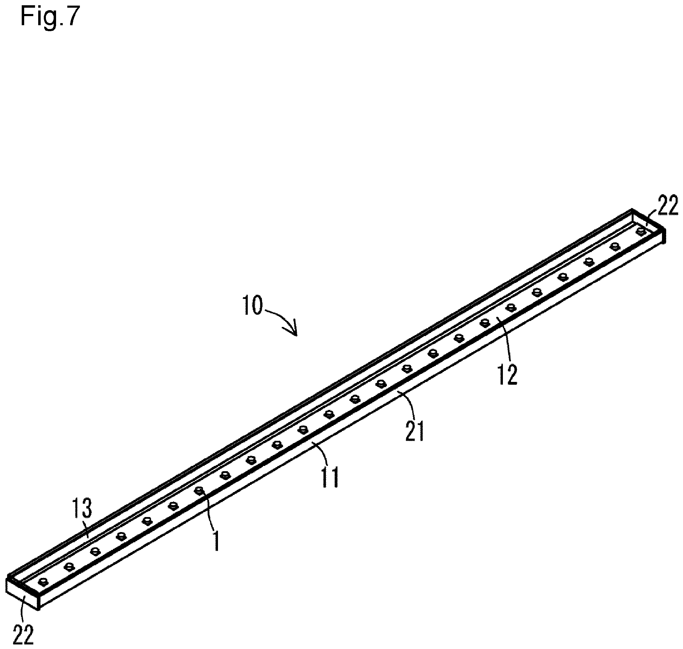

Fig. 1 is a perspective view of a light-emitting device 1 according to an embodiment of the present invention. Fig. 2 is a cross-sectional view of the light-emitting device 1 taken along a plane indicated by an imaginary line shown in Fig. 1. Fig. 3 is an enlarged cross-sectional view of a part of the light-emitting device 1 (part X surrounded by a two-dot chain line) shown in Fig. 2. Fig. 4 is a graph showing the spectrum of external emission light from the light-emitting device according to the embodiment of the present invention and the solar spectrum at a depth of about 50 m in the sea. Fig. 5 is a graph showing a solar spectrum at a water depth of 50 m in addition to the graph of Fig. 4. Fig. 6 is a graph showing the spectrum of external emission light from the light-emitting device according to the embodiment of the present invention and a solar spectrum at a depth of about 100 m in the sea. Fig. 7 is a perspective view of an illumination apparatus 10 according to the embodiment of the present invention. As shown in these figures, the light-emitting device 1 includes a substrate 2, a light emitter 3, a frame 4, a sealant 5, a coating 6, and phosphors 7. The illumination apparatus 10 includes at least one light-emitting device 1 described above and a mounting board 11 on which the light-emitting device 1 is mounted. The external emission light from the illumination apparatus 10 basically has the same spectrum as the spectrum of the external emission light from the light-emitting device 1.

In the present embodiment, the light-emitting device 1 includes the substrate 2, the light emitter 3 mounted on the substrate 2, the frame 4 located on an upper surface of the substrate 2 to surround the light emitter 3 in a plan view, the sealant 5 sealing the light emitter 3 within the frame 4, and the coating 6 located over the light emitter 3 with the sealant 5 between them. The coating 6 is located over a light-emitting portion 3a of the light emitter 3 and includes phosphors 7. The light emitter 3 is, for example, a light-emitting diode (LED), and emits light outward (upward in Fig. 2) when electrons and holes in the p-n junction in semiconductors are recombined.

The substrate 2 is, for example, a rectangular insulating substrate in a plan view and has a first surface on which the light emitter 3 is mounted (e.g., upper surface) and a second surface (e.g., lower surface) opposed to each other. The substrate 2 is formed from, for example, a ceramic material such as sintered aluminum oxide, sintered mullite, sintered aluminum nitride, or sintered silicon nitride, or a sintered glass ceramic material.

In some embodiments, the substrate 2 may be formed from a composite material containing two or more of these materials. In some embodiments, the substrate 2 may be formed from an organic resin containing fine particles (filler particles) of, for example, metal oxide in a dispersed manner to adjust the thermal expansion coefficient of the substrate 2. A material containing an organic resin may be an epoxy resin or a polyimide resin. The substrate 2 may thus be formed from an epoxy resin and reinforced with glass cloth.

The substrate 2 formed from, for example, sintered aluminum oxide may be prepared through the processes described below. Raw material powders such as aluminum oxide and silicon oxide are first mixed with an organic solvent and a binder, and the mixture is then kneaded to prepare slurry. The slurry is then shaped into a sheet with a method using, for example, a doctor blade, to obtain a ceramic green sheet. The ceramic green sheet is then cut into a predetermined shape and size to obtain multiple sheets. The sheets are stacked on one another as appropriate and collectively fired at temperatures of about 1300 to 1600 °C. The above processes complete the fabrication of the substrate 2.

The substrate 2 formed from, for example, an organic resin material such as an epoxy resin may be prepared with the method described below. An uncured epoxy resin material is shaped into a predetermined shape and size with, for example, injection molding or transfer molding, and is then cured with heat.

The substrate 2 has, on at least its main surface or inside, a wiring conductor that provides electrical connection between an inner space surrounded by the frame 4 and outside the frame 4. The wiring conductor is formed from, for example, a conductive material selected appropriately from tungsten, molybdenum, manganese, copper, silver, palladium, gold, titanium, and cobalt. The wiring conductor formed from such a metal material may additionally contain a conductive component such as carbon. The wiring conductor may also contain additives such as ceramic particles or glass particles. These additives can reduce a difference between the thermal expansion coefficients of the wiring conductor and the substrate 2.

For the substrate 2 formed from a ceramic material, the wiring conductor may be prepared as described below. A metal paste prepared by, for example, applying a metal paste containing powder of, for example, tungsten containing an organic solvent in a predetermined pattern to multiple sheets, which are to be the substrate 2, by printing. The multiple sheets are then stacked on one another and co-fired with the metal paste. This completes the wiring conductor for the substrate 2. The surface of the wiring conductor is plated with, for example, nickel or gold, for preventing oxidation or for improving wettability or other properties with a brazing material (described later).

For the substrate 2 formed from a material containing an organic resin, the wiring conductor may be prepared as described below. A film of the above metal material is formed on the surface of the organic resin material or on the inner wall of a via hole in the surface using a thin film deposition technique, such as vapor deposition or plating. Patterning such as etching or laser processing and via hole formation may also be used.

The surface of the substrate 2 on which the light emitter 3 is mounted (e.g., upper surface) may be coated with a metal reflective layer spaced from the wiring conductor and the plating layer to efficiently reflect light upward (outward) from the substrate 2. The metal reflective layer is formed from, for example, a metal material such as aluminum, silver, gold, copper, or platinum. The metal material may be formed into a metallization layer similarly to the wiring conductor or into a thin layer, such as a plated layer. The metal reflective layer may also include different forms of metal layers.

For the substrate 1 formed from a white ceramic material instead of having the metal reflective layer, at least the upper surface on which the light emitter 3 is mounted may be mirror-polished to increase the reflectance of light. The white ceramic material includes, for example, sintered aluminum oxide (with no pigment additive), sintered glass ceramic, and sintered mullite. The substrate 2 having a mirror-polished surface may be prepared using a sintered ceramic material of, for example, fine powder with a median particle diameter of about 0.5 µm or less.

The light emitter 3 is mounted on the upper surface of the substrate 2. The light emitter 3 is electrically and mechanically connected to the wiring conductor (or to the plating layer on it) on the upper surface of the substrate 2 with, for example, a brazing material or solder. The light emitter 3 includes a translucent base (with no labels) and the light-emitting portion 3a, which is an optical semiconductor layer located on the translucent base. The translucent base allows the optical semiconductor layer to be deposited by chemical vapor deposition, such as metal organic chemical vapor deposition or molecular beam epitaxy.

The translucent base may be formed from, for example, sapphire, gallium nitride, aluminum nitride, zinc oxide, zinc selenide, silicon carbide, silicon, or zirconium boride. The translucent base has a thickness of, for example, 50 to 1000 µm inclusive.

The optical semiconductor layer includes a first semiconductor layer formed on the translucent base, a light-emitting layer formed on the first semiconductor layer, and a second semiconductor layer formed on the light-emitting layer. The first semiconductor layer, the light-emitting layer, and the second semiconductor layer are formed from, for example, a group III nitride semiconductor, a group III-V semiconductor such as gallium phosphide or gallium arsenide, or a group III nitride semiconductor such as gallium nitride, aluminum nitride, or indium nitride. The first semiconductor layer has a thickness of, for example, 1 to 5 µm inclusive. The light-emitting layer has a thickness of, for example, 25 to 150 nm inclusive. The second semiconductor layer has a thickness of, for example, 50 to 600 nm inclusive. The light emitter 3 formed in this manner may emit excitation light with a wavelength range of, for example, 360 to 430 nm inclusive. More specifically, the light-emitting device 1 according to the embodiment emits light in the violet wavelength region (visible light).

The frame 4 is formed from, for example, a ceramic material such as aluminum oxide, titanium oxide, zirconium oxide, or yttrium oxide. The frame 4 may be formed from a porous material. The frame 4 may be formed from a resin material that is a mixture of powders of, for example, metal oxide such as aluminum oxide, titanium oxide, zirconium oxide, or yttrium oxide.

The frame 4 is bonded to the upper surface of the substrate 2 with, for example, a resin, a brazing material, or solder. The frame 4 may be formed from the same ceramic material as of the substrate 2, and may be formed by being co-fired with the substrate 2. The frame 4 is spaced from the light emitter 3 on the upper surface of the substrate 2 to surround the light emitter 3. The frame 4 has a sloping inner wall that flares away from the main surface of the substrate 2. The sloping inner wall of the frame 4 that flares away serves as a reflection surface for externally reflecting excitation light emitted from the light emitter 3. When the inner wall of the frame 4 is circular in a plan view, the reflection surface can uniformly reflect light emitted from the light emitter 3 externally.

The sloping inner wall of the frame 4 may have, for example, a metal layer of tungsten, molybdenum, or manganese formed on the inner periphery of the frame 4 formed from a sintered material, and a plating layer of nickel or gold covering the metal layer. The plating layer reflects light emitted from the light emitter 3. The inner wall of the frame 4 may have a slope angle (an angle between the inner wall of the frame and the main surface of the substrate 2 in a sectional view) of, for example, 55 to 70° inclusive with respect to the main surface of the substrate 2.

Similarly to the substrate 1, the frame 4 may be formed from a highly reflective ceramic material and may be mirror-polished on at least its inner surface. The frame 4 may be formed from a highly reflective ceramic material and may be mirror-polished in the same manner as for the substrate 2.

The inner space defined by the substrate 2 and the frame 4 is filled with the sealant 5, which transmits light. The sealant 5, which seals the light emitter 3, transmits light emitted from inside the light emitter 3 to outside the sealant 5.

The sealant 5 fills the inner space defined by the substrate 2 and the frame 4 except an area of the inner space defined by the frame 4. The sealant 5 may be, for example, a translucent insulating resin such as a silicone resin, an acrylic resin, or an epoxy resin, or translucent glass. The sealant 5 has a refractive index of, for example, 1.4 to 1.6 inclusive.

The coating 6 is located over the light-emitting portion 3a of the light emitter 3. More specifically, the coating 6 faces the upper surface of the light emitter 3 including the light-emitting portion 3a with the sealant 5 between them. In other words, the coating 6 faces the light-emitting portion 3a (the upper surface) that emits light from the light emitter 3. The light is then easily received by the phosphors 7 (described later).

As shown in Fig. 2, for example, the coating 6 is placed on the upper surface of the sealant 5 in the upper area of the inner space defined by the substrate 2 and the frame 4. The coating 6 is sized to fit inside the frame 4. The coating 6 converts the wavelength of light emitted from the light emitter 3. The coating 6 converts the wavelength using the phosphors 7 contained in the coating 6.

More specifically, the coating 6 receives the light emitted from the light emitter 3 through the sealant 5. The light emitted from the light emitter 3 excites the phosphors 7 in the coating 6 to emit fluorescence. In other words, the coating 6 converts the wavelength. The coating 6 also transmits and emits part of the light emitted from the light emitter 3. More specifically, external emission light through the coating 6 includes light emitted from the light emitter 3 (first emission light) and fluorescence emitted from the phosphors 7 (second emission light). The spectrum of the external emission light combines the spectra of the first emission light and the second emission light.

The coating 6 includes, for example, a translucent insulating resin such as a fluororesin, a silicone resin, an acrylic resin, or an epoxy resin, or translucent glass. The insulating resin or the glass contains the phosphors 7. The phosphors 7 are, for example, uniformly dispersed in the coating 6.

The light emitter 3 and the phosphors 7 contained in the coating 6 are selected to obtain the resulting light-emitting device 1 that externally emits light (external emission light or radiated light) with an emission spectrum shown in Fig. 4 or 5. In this case, the light emitter 3 emitting the first emission light may also be selected to have external emission light with the above spectrum. The above emission spectrum is measurable with, for example, various commercially available measuring instruments including a spectrometer and a control circuit.

Specific examples of the phosphors 7 for emitting the second emission light will now be described. In the example shown in Fig. 3, the phosphors 7 include a second phosphor 7b, in addition to a first phosphor 7a that emits fluorescence corresponding to a second peak wavelength λ2.

For example, the first phosphor 7a showing blue is (Sr, Ca, Ba)10(PO₄)₆C₁₂:Eu, and the second phosphor 7b showing blue-green is Sr₄Al₁₄O₂₅:Eu. The ratio of the elements in the parentheses may be changed as appropriate without deviating from the molecular formulas. The spectrum of external emission light in the blue to blue-green region may simulate the spectrum of sunlight more accurately using the second phosphor 7b.

In the light-emitting device 1 according to the present embodiment, the light emitter 3 emits the first emission light having a first peak wavelength λ1 in a range of 360 to 430 nm as described above. Also, the phosphors 7 emit the second emission light having a second peak wavelength λ2 in a range of 480 to 520 nm. The light-emitting device 1 externally emits light (external emission light) including the first emission light and the second emission light. The light has a peak region P having the first peak wavelength λ1 and the second peak wavelength λ2, a long wavelength region L defined between the second peak wavelength λ2 and a wavelength of 750 nm in which the light intensity decreases continuously, and a short wavelength region S defined between the first peak wavelength λ1 and an ultraviolet region in which the light intensity decreases continuously. Light intensity (W/m²/nm) refers to the irradiance of light per unit area and per unit wavelength.

In this case, the short wavelength region S (region having relatively shorter wavelengths) has an upper end within a wavelength region shorter than the first peak wavelength λ1 within the peak region P, and corresponds to the near-ultraviolet region with wavelengths shorter than, for example, about 360 nm. The long wavelength region L (region having relatively longer wavelengths) has a lower end within a wavelength region longer than the second peak wavelength λ2 within the peak region P, and corresponds to a yellow region with wavelengths longer than, for example, about 520 nm.

More specifically, the light-emitting device 1 according to the present embodiment emits external emission light having a light intensity with peaks in the violet region (wavelengths of 360 to 430 nm) and between the blue region and the green region (wavelengths of 480 to 520 nm). The light intensity gradually decreases from the green region toward and across the red region (wavelengths of 480 to 750 nm). The external emission light attenuates in the near-ultraviolet region. In other words, an object illuminated by the light-emitting device 1 according to the present embodiment is visually recognized as having relatively strong color tones of from violet to blue and green. Such colors (color tones) have the spectrum similar to the solar spectrum at a depth of about 50 m or more (e.g., about 50 to 100 m) in the sea.

The light-emitting device 1 according to the present embodiment thus allows easy fabrication of an illumination apparatus (e.g., the illumination apparatus 10 according to the present embodiment including at least one light-emitting device 1) suitable for illuminating various kinds of aquatic life living relatively deep in water at depths of, for example, about 50 to 100 m. Such aquatic life includes fishes and shellfishes such as sea breams, sea basses, and shrimps, cnidarians such as sea anemones, seaweeds, and eels. The illumination apparatus 10 according to the present embodiment can illuminate objects to be at depths of 50 to 100 m underwater. The illumination apparatus according to the present embodiment is thus suitable for raising (growing) and culturing the aquatic life described above. The illumination apparatus 10 including the light-emitting device 1 according to the embodiment will be described in detail later.

The aquatic life described above may be raised in an aquarium or indoors (on land) for such purposes as (personal) viewing, aquarium exhibition, culturing, and researching. The illumination apparatus including the light-emitting device 1 according to the embodiment can easily provide the aquatic life with raising environments appropriate for the above uses.

The light-emitting device 1 and the illumination apparatus 10 may be used appropriately for illumination indoors or on land for raising, investigating, researching, and (industrial) culturing of the fishes, seaweeds, or other living things living at intermediate depths in a shallow sea area. In other words, the light-emitting device 1 and the illumination apparatus 10 according to the embodiment may be used to provide effective lighting environments that allow accurate investigation, researching, and productive culturing of the aquatic life.

The aquatic life for viewing can be raised in an environment with color tones reproduced accurately from the color tones in their real underwater environments. The owner can thus view the aquatic life indoors with the color tones reproduced from real underwater environments. The light-emitting device 1 and the illumination apparatus 10 including the light-emitting device 1 may easily provide comfortable viewing environments. The light-emitting device 1 and the illumination apparatus 10 fabricated and to be sold may have higher added values (may be sold at higher prices).

The light-emitting device 1 and the illumination apparatus 10 may emit the first emission light having a light intensity of 70% or less of the light intensity of the second emission light. In the example shown in Fig. 4, for example, the first emission light at the first peak wavelength λ1 has a light intensity of 50% of the light intensity of the second emission light at the second peak wavelength λ2 (0.5 when the light intensity is 1).

As shown in Fig. 5, for example, the ratio of the light intensities of the first emission light and the second emission light allows the spectrum of visible light emitted from the light-emitting device 1 according to the embodiment to easily and effectively simulate the spectrum of visible light visually observed at depths of 50 to 100 m in the sea. The light emitted from the light-emitting device 1 has a light intensity in the near-ultraviolet region relatively lower than the light intensity in the visible light. This effectively reduces the likelihood that near-ultraviolet rays adversely affect the aquatic life (causing, for example, damage on the skin).

The light-emitting device 1 and the illumination apparatus 10 including the light-emitting device 1 may emit external emission light having, in the long wavelength region, a light intensity of 1 to 15% of the light intensity at the second peak wavelength λ2 in a wavelength region of 570 to 590 nm (yellow region), a light intensity of 0.3 to 5% of the light intensity at the second peak wavelength λ2 in a wavelength region of 590 to 620 nm (orange region), and a light intensity of 1% or less of the light intensity at the second peak wavelength λ2 in a wavelength region of 620 to 750 nm (red region). More specifically, the light-emitting device 1 may emit external emission light having a light intensity relatively high in the violet to blue region and in the green region, which greatly decreases from the yellow toward and across the red region (long wavelength region L) and includes almost no light components between the orange and red region (0% of the light intensity at the second peak wavelength λ2).

Light with a longer wavelength in the long wavelength region L has a lower light intensity. Thus, the light-emitting device 1 can reproduce attenuation of light components of sunlight in the long wavelength region underwater with the ratio of the green region toward and across the red region (particularly the red region) decreasing at larger depths with higher accuracy. The light-emitting device 1 and the illumination apparatus 10 can effectively reproduce lighting environments at the above depths (e.g., 50 to 100 m) in water.

The light-emitting device 1 and the illumination apparatus 10 including the light-emitting device 1 may also emit external emission light having a light intensity of 1% or less or 0% of the light intensity at the second peak wavelength λ2 in a wavelength region of 350 nm or less (short wavelength region S). More specifically, the light-emitting device 1 and the illumination apparatus 10 may emit external emission light having substantially no light components in the ultraviolet region (ultraviolet rays). The external emission light having the light intensity of 1% or less of the light intensity at the second peak wavelength λ2 in a wavelength region of less than 350 nm reduces the likelihood that ultraviolet rays adversely affect the aquatic life. The light-emitting device 1 can thus effectively reproduce lighting environments at intermediate depths in shallow sea areas that ultraviolet rays barely reach in nature.

At a greater depth in water (e.g., 100 m), external emission light may have a light intensity of 5% or less of the light intensity at the second peak wavelength λ2 in the wavelength region of 570 to 590 nm or may have a light intensity of 1% or less of the second peak wavelength λ2 in the wavelength region of 590 to 750 nm.

In Figs. 4 and 5, the light energy (J) in the above wavelength regions is represented by the area defined between a curve indicating the light intensity and a straight line indicating the relative intensity equal to zero (in other words, represented as an integrated or integral value of the light intensity per unit wavelength). In Figs. 4 and 5, a solid line indicates external emission light (radiated light) externally emitted from the light-emitting device 1. In Fig. 5, a dotted line indicates sunlight (in water).

Fig. 7 shows the illumination apparatus 10 according to the embodiment of the present invention. The illumination apparatus 10 according to the embodiment includes the light-emitting devices 1 with any of the structures described above mounted on the mounting board 11 as described above. In the example shown in Fig. 7, the mounting board 11 includes a base 12 that is a rectangular plate and a translucent lid 13 located above the base 12 to seal the light-emitting devices. The illumination apparatus 10 according to the embodiment further includes a housing 21 having grooves to receive the mounting board 11 and a pair of end plates 22 closing the ends of, or specifically the shorter sides of the housing 21.

More specifically, the illumination apparatus 10 that can be used for raising, for example, aquatic life, includes multiple light-emitting devices 1 mounted in a mounting space defined by the mounting board 11 including the translucent lid 13 and by the housing 21. The illumination apparatus 10 including the light-emitting devices 1 with the above structure is suitable for raising aquatic life living at depths of about 50 to 100 m in water (in the sea).

The mounting board 11 holds the multiple light-emitting devices 1 that are aligned with one another. The mounting board 11 also dissipates heat generated by the light-emitting devices 1 outside. The mounting board 11 is formed from, for example, a metal material such as aluminum, copper, or stainless steel, an organic resin material, or a composite material including these materials.

The mounting board 11 according to the present embodiment is an elongated rectangle in a plan view with a longitudinal length of, for example, 100 to 2000 mm inclusive. As described above, the mounting board 11 includes the base 12 having a mount area on its upper surface, on which the light-emitting devices 1 are mounted, and the translucent lid 13 sealing the mount area. The mounting board 11 is received in the grooves on the housing 21. The two ends of the grooves are closed with the end plates 22 to secure the mounting board 11 and the light-emitting devices 1 mounted on the mounting board 11 in the housing 21.

The base 12 may be, for example, a printed board such as a rigid printed board, a flexible printed board, or a rigid flexible printed board. The wiring pattern on the base 12 and the wiring conductor in the substrate 2 included in each light-emitting device 1 are electrically connected to each other with solder or conductive adhesive. An electric signal (current) from an external power source through the base 12 is transmitted to the light emitter 3 through the substrate 2. The light emitter 3 then emits light.

The lid 13 seals the light-emitting devices 1 and transmits the external emission light from the light-emitting devices 1 outside. The lid 13 is thus formed from a translucent material transmitting the external emission light. Examples of the translucent material include an acrylic resin and glass. The lid 13 is a rectangular plate (e.g., in the shape of an elongated rectangle similar to the base 12), and has a longitudinal length of, for example, 98 to 1998 mm inclusive.

The lid 13 is inserted through either of the two open ends of the grooves on the housing 21 in the longitudinal direction, is then slid in the longitudinal direction of the housing 21, and is thus positioned. As described above, the two ends of the grooves are closed with the end plates 22 to secure the lid 13 to the housing 21. This completes the illumination apparatus 10 including the multiple light-emitting devices 1 mounted on the mounting board 11 and sealed with the housing 21 and the lid 13.

The illumination apparatus 10 described above is a line emission apparatus including the multiple light-emitting devices 1 arranged linearly. In some embodiments, the illumination apparatus 10 may be a plane emission apparatus including multiple light-emitting devices 1 arranged in a matrix or in a staggered pattern. The mounting board 11 (or base 12) may not be an elongated rectangle in a plan view, and may be, for example, a square having a small aspect ratio, or in shapes other than a rectangle, such as a circle or an ellipse in a plan view. For example, to fit on an aquarium for raising aquatic life, the illumination apparatus 10 may include the mounting board 11 having the same shape as the aquarium (e.g., circular).

Multiple illumination apparatuses (the illumination apparatuses 10 according to the embodiment or the illumination apparatuses according to modifications as described above) each including the multiple light-emitting devices 1 mounted linearly on the mounting board 11 may be mounted on another substrate to form an illumination module used for raising aquatic life. The illumination apparatus 10 or the module described above may further include a sealant at a predetermined position such as between the housing 21 and the lid 13 to reduce water entry affecting the apparatus or the module, or may further include a moisture absorbent placed in the housing. The wiring conductor may be plated with a plating layer such as a gold plating layer.

### Reference Signs List

- 1: light-emitting device
- 2: substrate
- 3: light emitter
- 3a: light-emitting portion
- 4: frame
- 5: sealant
- 6: coating
- 7: phosphor
- 7a: first phosphor
- 7b: second phosphor
- 10: illumination apparatus
- 11: mounting board
- 12: base
- 13: lid
- 21: housing
- 22: end plate
- λ1: first peak wavelength
- λ2: second peak wavelength
- P: peak region
- L: long wavelength region
- S: short wavelength region

## Claims

1. A light-emitting device, comprising:
a light emitter including a light-emitting portion configured to emit first emission light having a first peak wavelength in a range of 360 to 430 nm; and
a coating located over the light-emitting portion of the light emitter, the coating containing a phosphor to emit, when excited by the first emission light, second emission light having a second peak wavelength in a range of 480 to 520 nm,
wherein the light-emitting device emits external emission light having a light intensity that decreases continuously from the second peak wavelength to a wavelength of 750 nm and from the first peak wavelength to a wavelength in a region of 360 nm or less, and having a peak region including the first peak wavelength and the second peak wavelength.

2. The light-emitting device according to claim 1, wherein
the first emission light has a light intensity that is 70% or less of a light intensity of the second emission light.

3. The light-emitting device according to claim 1 or claim 2, wherein
the light intensity of the external emission light is 1 to 15% of a light intensity at the second peak wavelength in a wavelength region of 570 to 590 nm, 0.3 to 5% of the light intensity at the second peak wavelength in a wavelength region of 590 to 620 nm, and 1% or less of the light intensity at the second peak wavelength in a wavelength region of 620 to 750 nm.

4. The light-emitting device according to any one of claims 1 to 3, wherein
the light intensity of the external emission light is 1% or less of a light intensity at the second peak wavelength in a wavelength region of 350 nm or less.

5. The light-emitting device according to claim 1 or claim 2, wherein
the light intensity of the external emission light is 5% or less of a light intensity at the second peak wavelength in a wavelength region of 570 to 590 nm, and 1% or less of the light intensity at the second peak wavelength in a wavelength region of 590 to 750 nm.

6. An illumination apparatus, comprising:
the light-emitting device according to any one of claims 1 to 5; and
a mounting board on which the light-emitting device is mounted.
